# EUROPÄISCHE PATENTSCHRIFT

(11) **EP 0 654 170 B1**
(45) Veröffentlichungstag und Bekanntmachung des Hinweises auf die Patenterteilung: **21.02.1996**
(21) Anmeldenummer: 92917215.3
(22) Anmeldetag: 07.08.1992
(51) Int. Cl.: H01H 37/76, H01H 85/00

(54) **THERMOSICHERUNG UND VERFAHREN ZU IHRER AKTIVIERUNG**
THERMAL CUT-OUT AND PROCESS FOR ACTIVATING IT
DISPOSITIF THERMIQUE DE SECURITE ET PROCEDE POUR L'ACTIVER

(43) Veröffentlichungstag der Anmeldung: 24.05.1995
(73) Patentinhaber: SIEMENS AKTIENGESELLSCHAFT, D-80333 München (DE)
(72) Erfinder: DREKMEIER, Karl, Gerd, D-82008 Unterhaching (DE); WINTER, Gerhard, D-81375 München (DE)
(86) Internationale Anmeldenummer: DE9200662
(87) Internationale Veröffentlichungsnummer: WO9403913

(56) Entgegenhaltungen:
- DE-B- 2 548 141
- GB-A- 2 077 500
- US-A- 3 613 040
- US-A- 3 763 454

## Beschreibung

Die Erfindung betrifft eine Thermosicherung zur Fixierung auf einem Schaltungssubstrat, mit einer aus einem schmalen Blechstreifen gebildeten Blattfeder, die an den Enden mindestens zwei Kontaktstellen, von denen mindestens eine eine Lötstelle ist, zur Verbindung mit entsprechenden Schaltungskontakten des Substrats sowie mindestens einen Federarm als Verbindung zwischen den Kontaktstellen aufweist. Außerdem betrifft die Erfindung gemäß Patentanspruch 15 ein Verfahren zur Aktivierung einer solchen Thermosicherung.

Derartige Sicherungen dienen zum Schutz von Schaltungsteilen vor thermischer Überlastung und können bei beliebigen Schaltungen, z.B. auf Leiterplatten, eingesetzt werden. Bevorzugtes Anwendungsgebiet der erfindungsgemäßen Thermosicherung sind jedoch Schichtschaltungen, insbesondere Hybridschaltungen.

Thermosicherungen der eingangs genannten Art sind allgemein bekannt, z.B. durch die DE-AS 1 515 624. Bei der dort für einen Widerstand verwendeten Sicherung wird der Federarm beim Einbau der Sicherung in seine Arbeitsposition vorgespannt, d.h. der Federarm muß durch eine besondere Vorrichtung während des Lötens und bis zum Erkalten der Lötverbindung in der Vorspannposition festgehalten werden. Dies erfordert besonders bei Schichtschaltungen eine komplizierte Handhabung und aufwendige Vorrichtungen.

Um das Einlöten unter Spannung zu vermeiden, hat man bei den durch die DE-PS 38 25 897 und die DE-OS 39 30 819 bekannten Thermosicherungen vorgesehen, die Federarme eines Sicherungsbügels mittels einer angeformten Abstützeinrichtung in ihrer vorgespannten Steilung zu halten, so daß während des Einlötens keine Spann- oder Haltevorrichtungen erforderlich sind. Die Abstützeinrichtung muß jedoch nach dem Löten entfernt oder freigebogen werden, um die Spannung der Federarme wirksam werden zu lassen. Außerdem haben diese in den meisten Anwendungsfällen an sich jedoch durchaus brauchbaren Thermosicherungen aufgrund ihrer Ausbildung mit zwei voneinander beabstandeten Federarmen und dazwischen angeformter Abstützeinrichtung einen bestimmten, in manchen Fällen aber kaum oder gar nicht zur Verfügung stehenden Raumbedarf, so daß sie bei beengten Platzverhältnissen nicht immer oder nur schwierig eingesetzt werden können.

Der Erfindung liegt daher die Aufgabe zugrunde, eine Thermosicherung der eingangs genannten Art zu schaffen, die weder eine Vorspannhalterung beim Einlöten noch eine eigene Abstützeinrichtung benötigt und insbesondere für miniaturisierte Bauformen bei beengten Platzverhältnissen geeignet ist.

Diese Aufgabe wird erfindungsgemäß dadurch gelöst, daß der Federarm nahe der einen Kontaktstelle mit einer dachartigen Ausformung ausgebildet ist, daß sich an diese Ausformung ein sich zur anderen Kontaktstelle hin erstreckender, eben und länglich ausgebildeter Federabschnitt anschließt, und daß der Federabschnitt im Bereich des Übergangs zu der Ausformung sowie im Bereich des Übergangs zu der anderen Kontaktstelle biegesteif ausgebildet ist, so daß eine Druckverformung der dachartigen Ausformung bei an beiden Enden und ohne Vorspannung auf dem Schaltungssubstrat fixierter Blattfeder in eine laterale Bewegung und in eine Aufwölbung des Federabschnittes umsetzbar ist.

Diese Thermosicherung wird weiterhin erfindungsgemäß in der Weise aktiviert, daß die Blattfeder mit ihren Kontaktstellen spannungsfrei auf die Schaltungskontakte des Schaltungssubstrates gelegt und damit verlötet wird, und daß nach dem Auflöten durch Druckverformung der dachartigen Ausformung eine Aufwölbung des Federabschnittes und damit die gewünschte Vorspannung erzeugt wird.

Bei der Erfindung wird die Blattfeder der Thermosicherung nicht vorgespannt und die Vorspannung der Blattfeder erst nach dem Fixieren der Blattfeder auf dem schaltungssubstrat erzeugt. Es ist somit weder eine Vorspannhalterung noch eine Abstützeinrichtung erforderlich. Dadurch und durch die Ausbildung der erfindungsgemäßen Thermosicherung mit einer in einen schmalen Blechstreifen leicht und in platzsparender Weise integrierbaren dachartigen Ausformung und mit einem sich daran anschließenden, die Federkraft speichernden Federabschnitt ist die Form der Blattfeder besonders einfach und wirtschaftlich in der Herstellung sowie in der Handhabung beim Einlöten. Die in einem Nutzenstreifen angeordnete, nicht vorgespannte Blattfeder wird in vorteilhafter Weise erst unmittelbar vor der Fixierung auf dem Schaltungssubstrat aus dem Nutzenstreifen herausgetrennt. Die nun einzelne, aber lagefixierte Blattfeder wird dann mittels einer Bestückeinrichtung lagerichtig auf dem entsprechend vorbereiteten Einbauplatz des Schaltungssubstrates, z.B. im Nutzen positioniert. Der gesamte Montagevorgang kann infolge der vorteilhaften Geometrie und der Anordnung der Blattfeder in einem Nutzenstreifen vollautomatisch erfolgen. Die gelöteten, auf einem Nutzen- oder Einzelsubstrat fixierten Thermosicherungen werden dann einzeln oder gemeinsam in einem einzigen Arbeitsschritt durch Druckverformung der dachartigen Teilgeometrie vorgespannt. Der Vorspannvorgang ist in besonders einfacher Weise auf dem Schaltungssubstrat durchführbar, wobei die Umsetzung der Druckverformung der dachartigen Ausformung in eine laterale Bewegung und in eine Aufwölbung des Federabschnittes in vorteilhafter Weise durch die biegesteifen Übergänge des Federabschnittes zur dachartigen Ausformung bzw. zur anderen Kontaktstelle unterstützt wird. Dadurch wird die Integration der die Vorspannung erzeugenden Elemente der Blattfeder in einen schmalen Blechstreifen ermöglicht, so daß die erfindungsgemäße Thermosicherung nur einen sehr geringen Platzbedarf hat und demzufolge insbesondere für miniaturierte Bauformen bei beengten Platzverhältnissen gut geeignet ist.

Bei einer zweckmäßigen, im Hinblick auf die Verformbarkeit der Ausformung und des Federabschnittes günstigen Ausführung ist die dachartige Ausformung durch zwei zueinander etwa senkrechte, über eine Dachkante miteinander verbundene Schenkel gebildet.

Bei einer erfindungsgemäßen Thermosicherung ist der Querschnitt der dachartigen Ausformung zumindest gegenüber dem Querschnitt des sich anschließenden Federabschnittes verringert. In diesem Fall wird durch die dachartige Ausformung mit verringertem Querschnitt im Zusammenwirken mit den biegesteifen Übergängen das Umsetzen des Verformungsweges in vorteilhafter Weise reproduzierbar in ein Vielfaches des Federweges eines Federarmendes ermöglicht, wobei der Federweg durch unterschiedlichen Verformungsweg beim Vorspannen variabel einstellbar ist.

Zweckmäßigerweise ist die dachartige Ausformung auch gegenüber der benachbarten Kontaktstelle im Querschnitt verringert.

Besonders günstige Stabilitätsverhältnisse zur reproduzierbaren Umsetzung einer Verformung von der Richtung, in der der Druck auf die Ausformung ausgeübt ist, z.B. von einer Z-Richtung, in die Richtung der lateralen Bewegung, z.B. in eine X-Richtung, stellen sich ein, wenn das Verhältnis des Querschnitts der dachartigen Ausformung zum Querschnitt des sich anschließenden Federabschnittes etwa 1 : 2 beträgt.

Vorzugsweise ist der Querschnitt der dachartigen Ausformung dadurch verringert, daß diese Ausformung in ihrer Breite schmaler ist als der sich anschließende Federabschnitt an der Übergangsstelle. Der Querschnitt der dachartigen Ausformung kann auch auf andere Weise, z.B. durch Ausnehmungen, reduziert werden.

Die gewünschte Biegesteifigkeit an den Übergängen des Federabschnittes wird in vorteilhafter Weise dadurch realisiert, daß der Federabschnitt nahe der Übergangsstelle zu der dachartigen Ausformung mit einem Biegeradius biegesteif abgewinkelt ist, und daß der Federabschnitt im Bereich des Übergangs zu der anderen Kontaktstelle durch eine Kröpfung biegesteif ausgebildet ist.

Im Hinblick auf die Federeigenschaften der Thermosicherung ist es vorteilhaft, wenn sich der Federabschnitt zur anderen Kontaktstelle hin verjüngt.

Ferner ist es im Hinblick auf den Montagevorgang der Thermosicherung von Vorteil, wenn die Enden der Blattfeder als in einer Ebene liegende, Lötanschlüsse bildende Kontaktlappen ausgebildet sind. Auf diese Weise sind die Blattfederenden für eine SMD-Montage- und Löttechnik geeignet ausgebildet, so daß auch mehrere Thermosicherungen gemeinsam in einem Arbeitsgang im Reflowverfahren gelötet werden können.

Die erfindungsgemäße Thermosicherung kann auch so ausgebildet sein, daß die Blattfeder zwei zueinander parallele Federarme aufweist, die an einem Ende zwei getrennte Kontaktstellen bilden und am gegenüberliegenden Ende miteinander verbunden sind. Dadurch ist die Thermosicherung als Doppelfeder für nebeneinanderliegende Kontaktstellen des Schaltungssubstrates geeignet ausgebildet, so daß die Federarme beim Aufschmelzen des Lotes an beiden Kontaktstellen die Trennung eines Stromkreises bewirken können. Diese Ausführungsform ist bei Kontaktstellen, die nicht sehr eng nebeneinander angeordnet werden können, günstig und besonders sicher.

Bei einer weiteren Ausführungsform können zwei nebeneinanderliegende Kontaktstellen aber auch mit einer Blattfeder mit nur einem Federarm kontaktiert werden, wenn die Blattfeder an einem Ende mit einem zwei getrennte Kontaktstellen des Schaltungssubstrates überbrückenden Kontaktlappen ausgebildet ist.

Weitere vorteilhafte Ausgestaltungen des Gegenstandes des Anspruchs 1 sowie des Verfahrens nach Anspruch 15 sind in den übrigen Unteransprüchen angegeben.

Die Erfindung wird im folgenden anhand von in der Zeichnung dargestellten Ausführungsbeispielen näher erläutert. Es zeigen
Fig. 1 und 2 in einer Draufsicht bzw. in einer Seitenansicht in einem Nutzenstreifen angeordnete, erfindungsgemäß ausgebildete Thermosicherungen,
Fig. 3 und 4 eine Thermosicherung in einer Draufsicht bzw. in einer Seitenansicht im auf einem Schaltungssubstrat montierten Zustand,
Fig. 5 in perspektivischer Darstellung eine Thermosicherung im ausgelösten Zustand,
Fig. 6 und 7 eine andere Ausführungsform einer Thermosicherung in einer Draufsicht bzw. in einer Seitenansicht im auf einem Schaltungssubstrat montierten Zustand,
Fig. 8 und 9 eine weitere Ausführungsform einer Thermosicherung in einer den Figuren 6 und 7 entsprechenden Darstellung und
Fig. 10 und 11 verschiedene in einem Nutzenstreifen angeordnete Ausführungen von Thermosicherungen in einer Draufsicht bzw. in einer Seitenansicht.

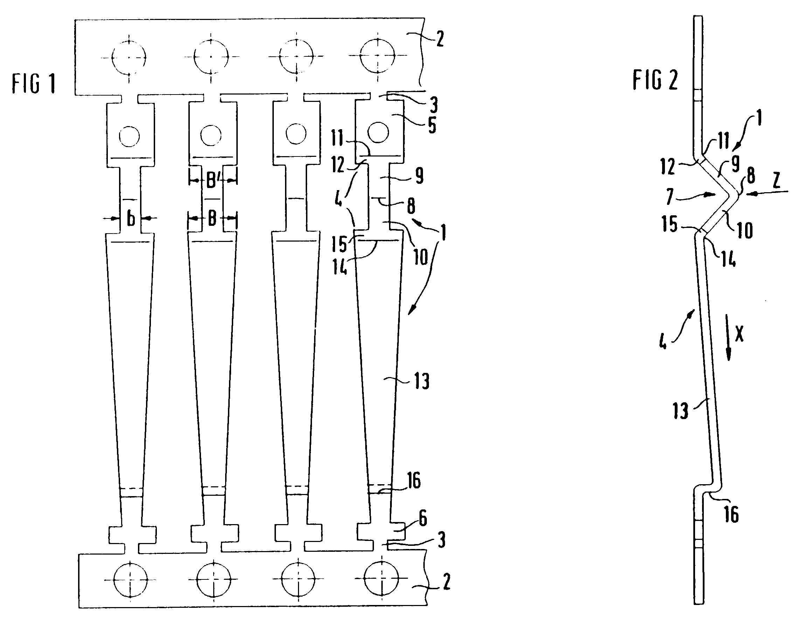

Die in der Zeichnung dargestellte Thermosicherung besteht aus einer aus einem Blechbiegestanzteil hergestellten Blattfeder 1, die - wie Fig. 1 zeigt - mit einer Vielzahl von weiteren Blatt federn im Nutzenstreifen zwischen zwei Transportstreifen 2 angeordnet ist. Das Heraustrennen einer Blattfeder 1 erfolgt in den Stegbereichen 3. Die Fig. 1 zeigt dabei deutlich den Zuschnitt der Blattfeder 1, d.h. die geometrische Form des eine Blattfeder bildenden Blechbiegestanzteiles. Dabei ist zu erkennen, daß die Blattfeder 1 aus einem schmalen Blechstreifen des Nutzens gebildet ist und im wesentlichen aus einem Federarm 4 besteht, der eine ganz bestimmte geometrische Form hat. An den beiden Enden weist der Federarm 4 in einer Ebene liegende, SMD-gerechte Lötanschlüsse bildende Kontaktlappen 5, 6 auf. Nahe des Kontaktlappens 5 ist der Federarm 4 mit einer dachartigen Ausformung 7 ausgebildet, die hier durch zwei zueinander etwa senkrechte, über eine Dachkante 8 miteinander verbundene Schenkel 9 und 10 gebildet ist und somit einen etwa V-förmigen Querschnitt hat. Eine dachartige Ausformung kann aber auch mit anderen Querschnittsformen gebildet werden. Die dachartige Ausformung 7 ist - wie die Fig.1 deutlich zeigt - schmaler als der Kontaktlappen 5, wobei dieser nahe der Übergangsstelle zu dem Schenkel 9 der Ausformung 7 unter einem Biegeradius 11 abgewinkelt ist und diese Abwinkelung 12 in den schmaleren Schenkel 9 übergeht, so daß sie praktisch eine breitere Basis für den schmalen Schenkel 9 bildet. An der anderen Seite der dachartigen Ausformung 7 schließt sich ein eben und länglich ausgebildeter Federabschnitt 13 an, der sich in Draufsicht gesehen trapezförmig verjüngend zu dem anderen Kontaktlappen 6 hin erstreckt, nahe der Übergangsstelle zu der dachartigen Ausformung 7 mit einem Biegeradius 14 abgewinkelt ist und im Bereich des Übergangs zu dem Kontaktlappen 6 eine stufenartige Kröpfung 16 aufweist. Dadurch ist der Federabschnitt 13 im Bereich des Übergangs zu der Ausformung 7 sowie im Bereich des Übergangs zu dem Kontaktlappen 6 jeweils biegesteif mit stabilen Winkelbereichen ausgebildet. Wie die Fig.1 zeigt, ist der Federabschnitt 13 an der Übergangsstelle zu der dachartigen Ausformung 7 deutlich breiter als diese, wobei die Abwinkelung 15 wie beim Kontaktlappen 5 in den schmaleren Schenkel 10 der Ausformung 7 übergeht und für diesen praktisch ebenfalls eine breitere Basis bildet. Dadurch, daß also die Breite b der dachartigen Ausformung 7 jeweils an der Übergangsstelle schmaler ist als die Breite B bzw. B' sowohl des Federabschnittes 13 als auch des Kontaktlappens 5, ist der Querschnitt der Ausformung 7 verringert. Eine Querschnittsverringerung kann jedoch auch durch andere Maßnahmen, wie z.B. Ausnehmungen in den Schenkeln der Ausformung, realisiert werden. Bei dem dargestellten Ausführungsbeispiel sind die Breiten B und B' gleich groß, wobei es sich als günstig herausgestellt hat, wenn die Breite B bzw. B' etwa zweimal so groß ist wie die Breite b der Ausformung 7, d.h. das Verhältnis des Querschnitts der Ausformung zum Querschnitt des Federabschnittes 13 wie auch des Kontaktlappens 5 beträgt etwa 1 : 2. Wie die Fig. 2 ferner noch zeigt, verläuft der Federabschnitt 13 durch die Abwinkelung am Biegeradius 14 in einem kleinen spitzen Winkel zur Ebene der Kontaktlappen 5 und 6. Mit der hier beschriebenen Ausgestaltung hat die Blattfeder 1 eine hinsichtlich der späteren Herstellung der Vorspannung für die Thermosicherung abgestimmte geometrische Form.

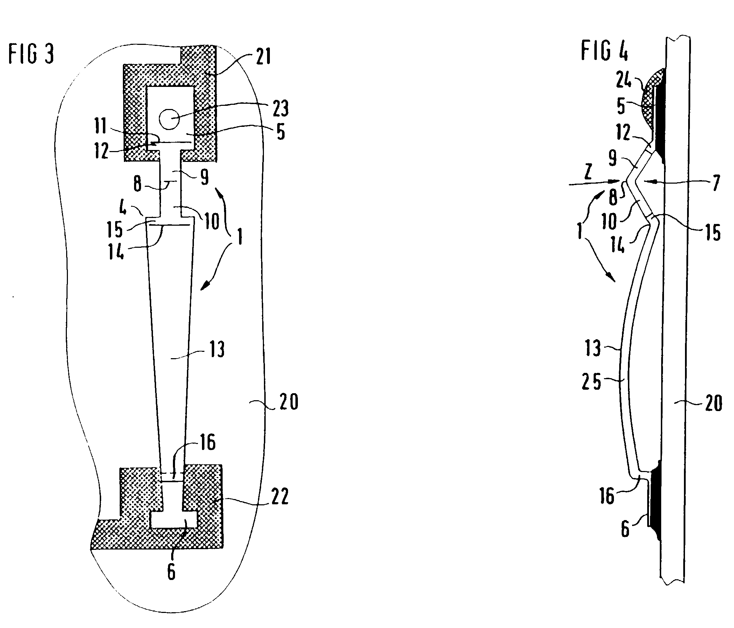

Die in Fig.l im Nutzenstreifen angeordneten, nicht vorgespannten Blatt federn 1 werden erst unmittelbar vor dem Fixieren auf einem Schaltungssubstrat 20, also z.B. unmittelbar vor einem Hybridiervorgang, aus dem Nutzenstreifen herausgetrennt. Die nun einzelnen, aber lagefixierten Blatt federn 1 werden dann mittels einer Bestückeinrichtung lagerichtig auf einem zweckmäßigerweise vorverzinnten Einbauplatz des Schaltungssubstrates 20, z.B. einer Hybridschaltung, positioniert, z.B. auf dem Substratnutzen. Der gesamte Montagevorgang kann durch die Geometrie und die Anordnung der Blatt federn in einem Nutzenstreifen vollautomatisch erfolgen. Aufgrund der SMD-gerechten Lötanschlüsse kann eine größere Anzahl von Blattfeder-Thermosicherungen gemeinsam im Reflowverfahren gelötet werden. Hierzu ist das Schaltungssubstrat 20 mit entsprechenden Schaltungskontakten 21 bzw. 22 für die Anlötung der Kontaktlappen 5 und 6 einer jeden Blattfeder ausgebildet, wobei es zweckmäßig ist, wenn - wie die Fig. 3 ebenfalls zeigt - die Lötstellenbelastbarkeit durch Formschluß mittels Querschnittsänderungen an den Enden der Blattfeder 1 unterstützt wird. Hier ist dies dadurch realisiert, daß der Kontaktlappen 5 mit einem Loch 23 versehen und der Kontaktlappen 6 breiter ausgebildet ist als das angrenzende Ende des Federabschnittes 13. Wie die Fig.4 zeigt, kann das Federende mit dem Kontaktlappen 5 zusätzlich noch mit einem Gießharztropfen 24 gesichert sein.

Die Figuren 3 und 4 zeigen die Blattfeder 1 einer Thermosicherung im vorgespannten Zustand. Die Vorspannung einer oder mehrerer gelöteter, auf einem Nutzen- oder einem Einzelsubstrat befindlicher Thermosicherungen kann nun für jede Blattfeder einzeln oder auch gemeinsam in einem einzigen Arbeitsschritt durch Verformung der dachartigen Ausformung 7 erzeugt werden. Hierzu wird auf die in Fig.2 im nicht vorgespannten Zustand, den die Blattfeder 1 auch noch im gelöteten Einbauzustand einnimmt, gezeigte Blattfeder in Richtung des Pfeiles Z eine geringe Druckkraft, z.B. auf die Dachkante 8 der Ausformung 7 ausgeübt. Diese Druckkraft erzeugt eine laterale Bewegung des Federabschnittes 13, d.h. eine seitliche Verschiebung der am Schaltungssubstrat 20 sich zunächst mit dem Biegeradius 14 abstützenden Abwinkelung 15 in Längsrichtung des Federabschnittes, also in X-Richtung und von der Ausformung 7 weg und wird in eine in Fig.4 deutlich erkennbare brückenbogenähnliche Aufwölbung 25 des Federabschnittes 13 umgesetzt, wobei die erzeugte Federspannung durch die Aufwölbung 25 gekennzeichnet ist. Das Verhältnis des Verformungsweges in X-Richtung zum späteren Federweg des mit dem Kontaktlappen 6 ausgebildeten Federendes im entspannten Zustand kann z.B. 1 : 4 sein, d.h. bei einem Verformungsweg von 2/10 Millimeter in Z-Richtung ergibt sich ein Federweg in X-Richtung von 8/10 Millimeter. Mit diesem Übersetzungsverhältnis können ohne Änderung der eigentlichen Geometrie der Thermosicherung verschiedene Federwege eingestellt werden. Die bei der erfindungsgemäßen Thermosicherung gegebenen, durch die biegesteifen Übergänge des Federabschnittes 13 erzielten Stabilitätsverhältnisse ermöglichen ein reproduzierbares Umsetzen einer Verformung von der Z-Richtung in die X-Richtung. Im vorgespannten Zustand ist die Blattfeder 1 und damit die Thermosicherung nunmehr aktiviert.

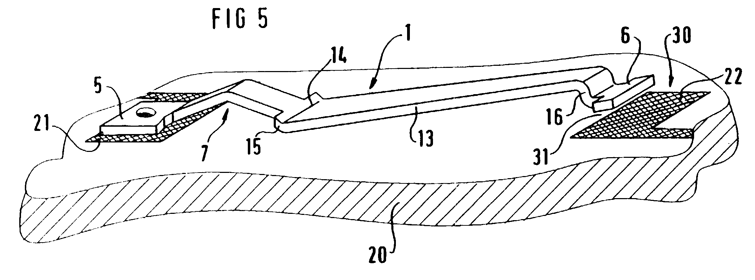

Bei entsprechend starker Erwärmung des gesicherten Schaltungsbereiches durch Überlastung schmilzt das Lot an der Einspannstelle 30 (Fig.5) der Blattfeder 1, so daß sich der unter Vorspannung stehende Federabschnitt 13 entspannt und vom Schaltungssubstrat 20 abhebt, somit die gewünschte Stromkreisunterbrechung herbeiführt und eine Beschädigung der Baugruppe verhindert. Hierbei sorgt der einstellbare Öffnungsabstand 31 für eine gesicherte galvanische Stromkreistrennung.

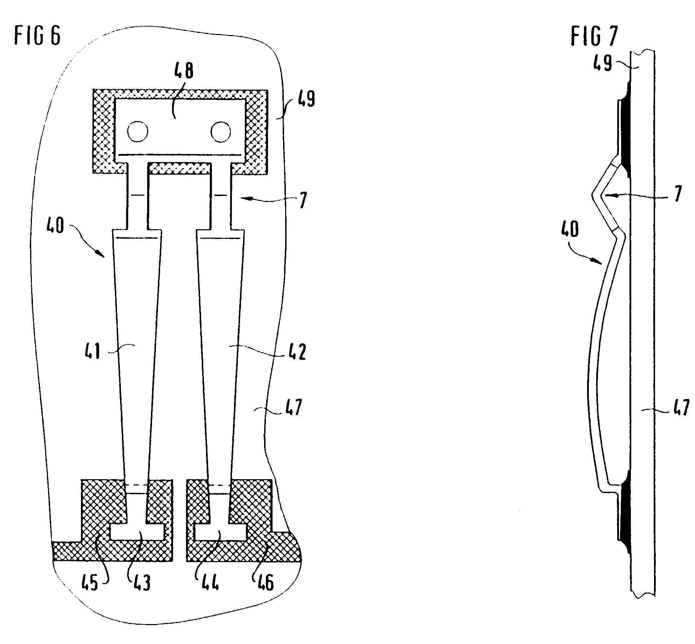

In weiterer Ausführung zeigen die Figuren 6 und 7 die Thermosicherung als Doppelfeder. Hierbei weist die Blattfeder 40 zwei zueinander parallele, nach der Beschreibung zu den Figuren 1 und 2 gestaltete Federarme 41 und 42 auf, die an einem Ende mit ihren Kontaktlappen 43,44 zwei getrennte Kontaktstellen 45,46 des Schaltungssubstrates 47 überbrücken und am anderen gegenüberliegenden Ende 48 miteinander verbunden und - schaltungsabhängig - leitend oder isoliert auf der Oberfläche 49 des Schaltungssubstrates fixiert sind. Bei dieser Ausführung und Anordnung können die Federarme 41,42 beim Aufschmelzen des Lotes entweder an der Kontaktstelle 45 oder an der Kontaktstelle 46 die Trennung eines Stromkreises bewirken.

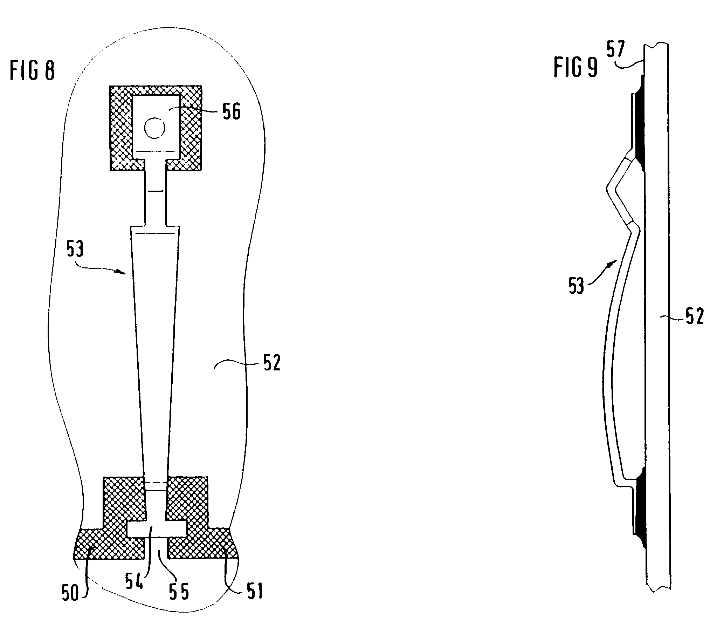

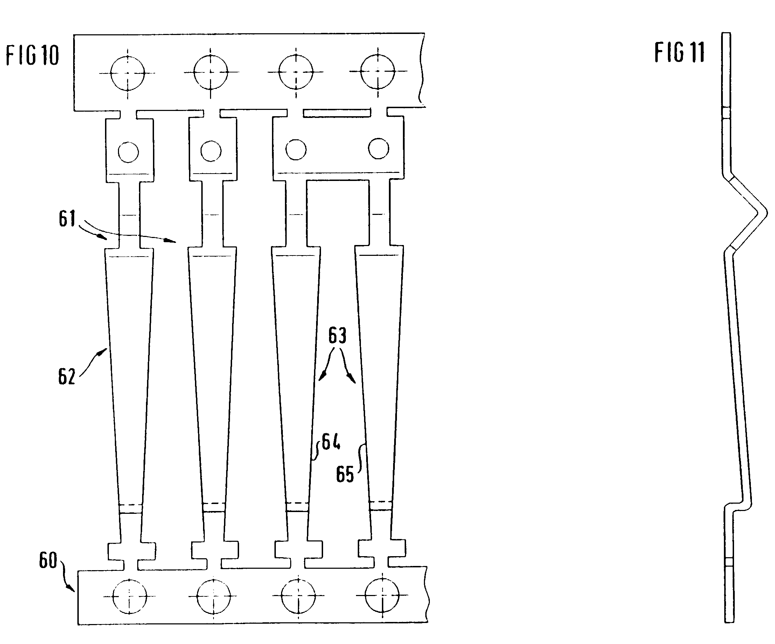

Bei einer weiteren Ausführungsform nach den Figuren 8 und 9 sind zwei Kontaktstellen 50,51 eines Schaltungssubstrates 52 dadurch mit nur einer Blattfeder 53 kontaktiert, daß der Kontaktlappen 54 der ansonsten wie nach den Figuren 1 und 2 ausgebildeten Blattfeder so breit ausgeführt ist, daß er den Abstand 55 der Kontaktstellen 50,51 entsprechend überdeckt. Das gegenüberliegende Federende 56 ist - schaltungsabhängig - leitend oder isoliert mit der Oberfläche 57 des Schaltungssubstrates 52 verbunden.

Schließlich ist in den Figuren 10 und 11 noch ein Nutzenstreifen 60 dargestellt, der sowohl Blatt federn 61 mit einem einzigen Federarm 62 als auch als Doppelfedern ausgebildete Blatt federn 63 mit zwei zueinander parallelen Federarmen 64,65 enthält. Dies ist wahlweise durch das Ziehen eines Schneidstempels mit ein und demselben Werkzeug realisierbar.

## Patentansprüche

1. Thermosicherung zur Fixierung auf einem Schaltungssubstrat (20), mit einer aus einem schmalen Blechstreifen gebildeten Blattfeder (1, 53, 40), die an den Enden mindestens zwei Kontaktstellen (5,6, 50, 51, 45, 46), von denen mindestens eine eine Lötstelle ist, zur Verbindung mit entsprechenden Schaltungskontakten (21,22) des Substrats (20) sowie mindestens einen Federarm (4) als Verbindung zwischen den Kontaktstellen (5,6) aufweist,
**dadurch gekennzeichnet**, daß der Federarm (4) nahe der einen Kontaktstelle (5) mit einer dachartigen Ausformung (7) ausgebildet ist, daß sich an diese Ausformung (7) ein sich zur anderen Kontaktstelle (6) hin erstreckender, eben und länglich ausgebildeter Federabschnitt (13) anschließt, und daß der Federabschnitt (13) im Bereich des Übergangs zu der Ausformung (7) sowie im Bereich des Übergangs zu der anderen Kontaktstelle (6) biegesteif ausgebildet ist, so daß eine Druckverformung der dachartigen Ausformung (7) bei an beiden Enden und ohne Vorspannung auf dem Schaltungssubstrat (20) fixierter Blattfeder (1) in eine laterale Bewegung und in eine Aufwölbung (25) des Federabschnittes (13) umsetzbar ist.

2. Thermosicherung nach Anspruch 1,
**dadurch gekennzeichnet**, daß die dachartige Ausformung (7) durch zwei zueinander etwa senkrechte, über eine Dachkante (8) miteinander verbundene Schenkel (9,10) gebildet ist.

3. Thermosicherung nach Anspruch 1 oder 2,
**dadurch gekennzeichnet**, daß der Querschnitt der dachartigen Ausformung (7) zumindest gegenüber dem Querschnitt des sich anschließenden Federabschnittes (13) verringert ist.

4. Thermosicherung nach Anspruch 3,
**dadurch gekennzeichnet**, daß das Verhältnis des Querschnitts der dachartigen Ausformung (7) zum Querschnitt des sich anschließenden Federabschnittes (13) etwa 1 : 2 beträgt.

5. Thermosicherung nach Anspruch 3 oder 4,
**dadurch gekennzeichnet**, daß der Querschnitt der dachartigen Ausformung (7) dadurch verringert ist, daß diese Ausformung in ihrer Breite (b) schmaler ist als der sich anschließende Federabschnitt (13) an der Übergangsstelle.

6. Thermosicherung nach einem der Ansprüche 1 bis 5,
**dadurch gekennzeichnet**, daß der Federabschnitt (13) nahe der Übergangsstelle zu der dachartigen Ausformung (7) mit einem Biegeradius (14) biegesteif abgewinkelt ist.

7. Thermosicherung nach einem der vorhergehenden Ansprüche, **dadurch gekennzeichnet**, daß der Federabschnitt (13) im Bereich des Übergangs zu der anderen Kontaktstelle (6) durch eine Kröpfung (16) biegesteif ausgebildet ist.

8. Thermosicherung nach einem der vorhergehenden Ansprüche, **dadurch gekennzeichnet**, daß sich der Federabschnitt (13) zur anderen Kontaktstelle (6) hin verjüngt.

9. Thermosicherung nach einem der vorhergehenden Ansprüche, **dadurch gekennzeichnet**, daß die Enden der Blattfeder (1) als in einer Ebene liegende, Lötanschlüsse bildende Kontaktlappen (5,6) ausgebildet sind.

10. Thermosicherung nach einem der vorhergehenden Ansprüche, **dadurch gekennzeichnet**, daß an den mit dem Schaltungssubstrat (20) verlötbaren Kontaktstellen (5,6) der Blattfeder (1) Querschnittsänderungen vorgenommen sind.

11. Thermosicherung nach einem der vorhergehenden Ansprüche, **dadurch gekennzeichnet**, daß die Blattfeder (53) an einem Ende mit einem zwei getrennte Kontaktstellen (50,51) des Schaltungssubstrates (52) überbrückenden Kontaktlappen (54) ausgebildet ist.

12. Thermosicherung nach einem der Ansprüche 1 bis 10, **dadurch gekennzeichnet**, daß die Blattfeder (40) zwei zueinander parallele Federarme (41,42) aufweist, die an einem Ende zwei getrennte Kontaktstellen (45,46) bilden und am gegenüberliegenden Ende (48) miteinander verbunden sind.

13. Thermosicherung nach einem der vorhergehenden Ansprüche, **dadurch gekennzeichnet,** daß die Blattfeder (1) in einem Nutzenstreifen angeordnet und unmittelbar vor der Fixierung auf dem Schaltungssubstrat (20) aus dem Nutzenstreifen herausgetrennt und in dadurch lagefixierter Position mittels einer Bestückeinrichtung im nicht vorgespannten Zustand auf dem Schaltungssubstrat (20) fixiert ist.

14. Thermosicherung nach einem der vorhergehenden Ansprüche, **dadurch gekennzeichnet**, daß ein Federende der Blattfeder (1) im auf dem Schaltungssubstrat (20) fixierten Zustand zusätzlich z.B. mit einem Gießharztropfen (24) gesichert ist.

15. Verfahren zur Aktivierung einer Thermosicherung nach einem der Ansprüche 1 bis 14,
**dadurch gekennzeichnet**, daß die Blattfeder (1) mit ihren Kontaktstellen (5,6) spannungsfrei auf die Schaltungskontakte (21,22) des Schaltungssubstrates (20) gelegt und damit verlötet wird, und daß nach dem Auflöten durch Druckverformung der dachartigen Ausformung (7) eine Aufwölbung (25) des Federabschnittes (13) und damit die gewünschte Vorspannung erzeugt wird.

16. Verfahren nach Anspruch 15,
**dadurch gekennzeichnet**, daß die Aufwölbung (25) des Federabschnittes (13) durch seitliche Verschiebung der am Schaltungssubstrat (20) sich abstützenden Abwinkelung (15) des Federabschnittes (13) in dessen Längsrichtung und von der dachartigen Ausformung (7) weg erfolgt.

17. Verfahren nach Anspruch 15 oder 16,
**dadurch gekennzeichnet**, daß die Druckkraft auf die Dachkante (8) einer zweischenkeligen dachartigen Ausformung (7) ausgeübt wird.

## Claims

1. Fuse for fixing on a circuit substrate (20), having a leaf spring (1, 53, 40) which is formed from a narrow sheet-metal strip and has, at its ends, at least two contact points (5, 6, 50, 51, 45, 46), of which at least one is a soldering point, for connecting to corresponding circuit contacts (21, 22) of the substrate (20), as well as at least one spring arm (4) as connection between the contact points (5, 6), characterized in that the spring arm (4) is designed, close to the one contact point (5), with a roof-shaped bulge (7), in that this bulge (7) is adjoined by a spring section (13) which extends to the other contact point (6), is of flat and elongate design, and in that the spring section (13) is designed to be elastically stiff in the region of the transition to the bulge (7) as well as in the region of the transition to the other contact point (6), so that a pressure deformation of the roof-like bulge (7) can be converted into a lateral movement and into an upward doming (25) of the spring section (13) when the leaf spring (1) is fixed at both ends and without prestress on the circuit substrate (20).

2. Fuse according to Claim 1, characterized in that the roof-like bulge (7) is formed by two limbs (9, 10) which are interconnected by means of a roof edge (8) and are approximately perpendicular relative to one another.

3. Fuse according to Claim 1 or 2, characterized in that the cross-section of the roof-like bulge (7) is reduced at least with respect to the cross-section of the adjoining spring section (13).

4. Fuse according to Claim 3, characterized in that the ratio of the cross-section of the roof-like bulge (7) to the cross-section of the adjoining spring section (13) is approximately 1:2.

5. Fuse according to Claim 3 or 4, characterized in that the cross-section of the roof-like bulge (7) is reduced by the fact that this bulge is narrower in terms of its width (b) than the adjoining spring section (13) at the transition point.

6. Fuse according to one of Claims 1 to 5, characterized in that the spring section (13) is angled, so as to be elastically stiff, close to the transition point to the roof-like bulge (7) with a bending radius (14).

7. Fuse according to one of the preceding claims, characterized in that the spring section (13) is designed, so as to be elastically stiff, by a double bend (16) in the region of the transition to the other contact point (6).

8. Fuse according to one of the preceding claims, characterized in that the spring section (13) tapers towards the other contact point (6).

9. Fuse according to one of the preceding claims, characterized in that the ends of the leaf spring (1) are designed as contact tabs (5, 6) which lie in one plane and form soldering connections.

10. Fuse according to one of the preceding claims, characterized in that changes in cross-section are performed at those contact points (5, 6) of the leaf spring (1) which can be soldered to the circuit substrate (20).

11. Fuse according to one of the preceding claims, characterized in that the leaf spring (53) is designed at one end with a contact tab (54) which bridges two separate contact points (50, 51) of the circuit substrate (52).

12. Fuse according to one of Claims 1 to 10, characterized in that the leaf spring (40) has two mutually parallel spring arms (41, 42) which form, at one end, two separate contact points (45, 46) and are interconnected at the opposite end (48).

13. Fuse according to one of the preceding claims, characterized in that the leaf spring (1) is arranged in a blank strip and separated from the blank strip immediately prior to fixing on the circuit substrate (20) and is fixed in a position which, in consequence, is fixed in terms of location, on the circuit substrate (20) in the unstressed state by means of a mounting device.

14. Fuse according to one of the preceding claims, characterized in that one spring end of the leaf spring (1) is additionally secured e.g. by means of a drop (24) of casting resin in the state in which it is fixed on the circuit substrate (20).

15. Method for activating a fuse according to one of Claims 1 to 14, characterized in that the leaf spring (1) is placed without stress with its contact points (5, 6) onto the circuit contacts (21, 22) of the circuit substrate (20) and is soldered thereto, and in that, after the soldering, an upward doming (25) of the spring section (13) and in consequence the desired prestress are produced by pressure deformation of the roof-like bulge (7).

16. Method according to Claim 15, characterized in that the upward doming (25) of the spring section (13) is carried out by lateral displacement of that angle (15) of the spring section (13), which is supported on the circuit substrate (20), in its longitudinal direction and away from the roof-like bulge (7).

17. Method according to Claim 15 or 16, characterized in that the pressure force is exerted onto the roof edge (8) of a two-limb roof-like bulge (7).

## Revendications

1. Coupe-circuit sensible à la température destiné à être fixé sur un substrat porte-circuit (20), comportant un ressort à lames (1,53,40) formé d'une étroite bande de tôle et qui a, aux extrémités, au moins deux emplacements de contact (5,6,50,51,45,46), dont l'un au moins est un emplacement de brasage et qui sont destinés à la liaison avec des contacts correspondants (21,22) du circuit du substrat (20), ainsi qu'au moins un bras (4) de ressort en tant qu'élément de liaison entre les emplacements de contact (5,6),
caractérisé par le fait que le bras (4) du ressort est agencé, à proximité d'un (5) des emplacements de contact, en ayant un toit (7), un tronçon plat et oblong (13) du ressort, qui s'étend jusqu'à l'autre emplacement de contact (6), se raccorde à ce toit (7), le tronçon (13) du ressort est agencé de manière à résister à la flexion dans la zone de jonction avec le toit (7) ainsi que dans la zone de jonction avec l'autre emplacement de contact (6), de sorte qu'une déformation par pression sur le toit (7) puisse être convertie en un déplacement latéral et en un cintrage (25) du tronçon (13) du ressort, dans le cas où le ressort à lames (1) est fixé à ses deux extrémités et sans précontrainte sur le substrat porte-circuit (20).

2. Coupe-circuit sensible à la température suivant la revendication 1, caractérisé par le fait que le toit (7) est formé de deux versants (9,10) approximativement perpendiculaires l'un à l'autre et reliés entre eux par l'intermédiaire d'une arête (8) du toit.

3. Coupe-circuit sensible à la température suivant la revendication 1 ou 2, caractérisé par le fait que la section transversale du toit (7) est réduite au moins par rapport à la section transversale du tronçon (13) du ressort, qui s'y raccorde.

4. Coupe-circuit sensible à la température suivant la revendication 3, caractérisé par le fait que le rapport de la section transversale du toit (7) à la section transversale du tronçon (13) du ressort, qui s'y raccorde, est égale à environ 1:2.

5. Coupe-circuit sensible à la température suivant la revendication 3 ou 4, caractérisé par le fait que la section transversale du toit (7) est réduite par le fait que ce toit a une largeur (b) qui est inférieure à celle du tronçon (13) du ressort, qui s'y raccorde, à la zone de jonction.

6. Coupe-circuit sensible à la température suivant l'une des revendications 1 à 5, caractérisé par le fait que le tronçon (13) du ressort est coudé avec un rayon de courbure (14), de manière à résister à la flexion, à proximité de la zone de jonction avec le toit (7).

7. Coupe-circuit sensible à la température suivant l'une des revendications précédentes, caractérisé par le fait que le tronçon (13) du ressort a la forme d'une coude (16), résistant à la flexion, dans la zone de la jonction avec l'autre emplacement de contact (6).

8. Coupe-circuit sensible à la température suivant l'une des revendications précédentes, caractérisé par le fait que le tronçon (13) du ressort se rétrécit en direction de l'autre zone de contact (6).

9. Coupe-circuit sensible à la température suivant l'une des revendications précédentes, caractérisé par le fait que les extrémités du ressort à lames (1) sont sous la forme de pattes de contact (5,6), qui sont situées dans un plan et forment des bornes à braser.

10. Coupe-circuit sensible à la température suivant l'une des revendications précédentes, caractérisé par le fait que des modifications de la section transversale sont effectuées aux emplacements de contact (5,6) du ressort à lames (1), qui peuvent être fixés par brasage au substrat porte-circuit (20).

11. Coupe-circuit sensible à la température suivant l'une des revendications précédentes, caractérisé par le fait que le ressort à lames (53) comporte, à une extrémité, une patte de contact (54) qui ponte deux emplacements séparés de contact (50,51) du substrat porte-circuit (52).

12. Coupe-circuit sensible à la température suivant l'une des revendications 1 à 10, caractérisé par le fait que le ressort à lames (40) comporte deux bras parallèles (41,42) l'un à l'autre, qui forment, à une extrémité, deux emplacements de contact séparés (45,46) et sont reliés entre eux à l'extrémité opposée (48).

13. Coupe-circuit sensible à la température suivant l'une des revendications précédentes, caractérisé par le fait que le ressort à lames (1) est disposé dans une bande mère, est séparé de la bande mère juste avant la fixation sur le substrat porte-circuit (20) et est bloqué à l'état non précontraint dans une position ainsi fixée, sur le substrat porte-circuit (20), à l'aide d'un dispositif d'équipement.

14. Coupe-circuit sensible à la température suivant l'une des revendications précédentes, caractérisé par le fait qu'une extrémité du ressort à lames (1) est bloquée en supplément par exemple à l'aide d'une goutte de résine de coulée (24), lorsqu'il est fixé sur le substrat porte-circuit (20).

15. Procédé pour activer un coupe-circuit sensible à la température suivant l'une des revendications 1 à 14, caractérisé par le fait qu'on pose le ressort à lames (1) sans contrainte, par ses emplacements de contact (5,6), sur les contacts (21,22) du circuit du substrat porte-circuit (20), qu'on les y fixe par brasage et qu'après le brasage, on crée, par déformation par pression sur le toit (7), un cintrage (25) du tronçon (13) du ressort et que l'on produit de ce fait la précontrainte souhaitée.

16. Procédé suivant la revendication 15, caractérisé par le fait que le cintrage (25) du tronçon (13) du ressort s'effectue par déplacement latéral du coude (15), qui prend appui sur le substrat porte-circuit (20), du tronçon (13) du ressort, dans sa direction longitudinale et en s'éloignant du toit (7).

17. Procédé suivant la revendication 15 ou 16, caractérisé par le fait que l'on applique la force de pression à l'arête (8) d'un toit (7) à deux versants.
